# EUROPÄISCHE PATENTSCHRIFT

(11) **EP 1 473 866 B1**
(45) Veröffentlichungstag und Bekanntmachung des Hinweises auf die Patenterteilung: **30.08.2006**
(21) Anmeldenummer: 04009616.6
(22) Anmeldetag: 23.04.2004
(51) Int. Cl.: H04K 3/00, H03K 3/78, H03K 3/537, H03B 11/02

(54) **Mikrowellengenerator zum Abstrahlen von Mikrowellenenergie**
Microwave generator for the emission of microwave energy
Générateur de micro-ondes pour l'émission d'énergie hyperfréquence

(30) Priorität: 29.04.2003 DE 10319475
(43) Veröffentlichungstag der Anmeldung: 03.11.2004
(73) Patentinhaber: Diehl BGT Defence GmbH & Co.KG, 88662 Überlingen (DE)
(72) Erfinder: Urban, Jürgen, Dr., 91058 Erlangen (DE); Hofmann, Helmut, 91322 Gräfenberg (DE); Dommer, Josef, 90451 Nürnberg (DE); Staines, Geoffrey, Dr., 90552 Röthenbach (DE)
(74) Vertreter: Diehl Patentabteilung

(56) Entgegenhaltungen:
- DE-B- 1 591 225
- US-A- 5 293 527
- US-A1- 2003 076 044

## Beschreibung

Die Erfindung betrifft einen Mikrowellengenerator und ein Verfahren zum Abstrahlen von Mikrowellenenergie gemäß dem jeweiligen Oberbegriff der Hauptansprüche.

Generell führt es zum impulsförmigen Abstrahlen von Energie im Mikrowellenspektrum, wenn eine Hochspannungsbatterie, etwa ein gemäß dem Prinzip der Marx'schen Stoßspannungsschaltung parallel aufgeladene und dann über Schalt-Funkenstrecken in Serie geschaltete Kondensatorbatterie, über eine Funkenstrecke entladen wird. Denn damit ist ein steil einsetzender und stark oszillierender impulsförmiger Stromfluss durch die Kondensatorschaltung und durch einen unter Umständen daran angeschlossenen Antennenleiter verbunden, also eine entsprechend breitbandige Abstrahlung eines Mikrowellenspektrums hoher Energiedichte. In der näheren Umgebung kann davon Funkverkehr zumindest beeinträchtigt und eine elektronische Schaltung insbesondere eingangsseitig gestört oder sogar zerstört werden.

Um Mikrowellenenergie gezielt in einen Hohlleiter einzustrahlen, ist es aus der US 3,748,528 A bekannt, eine im Umriss flaschenförmige Elektrode mit balligem Boden in den Hohlleiter hineinragen zu lassen, um mit dem gegenüberliegenden Wandungsbereich des Hohlleiters eine Funkenstrecke zu bilden. Das dagegen flache, gegenüberliegende Stirnende, gewissermaßen der Flaschenhals, jener Elektrode ragt als Elektrode einer weiteren, als Pulsformer ausgelegten, Funkenstrecke in einen mit Schutzgas gefüllten Hohlraum hinein. Deren Gegenelektrode ist das flache Stirnende des Innenleiters einer Koaxialanordnung. Dieser Innenleiter wird der Funkenstrecke gegenüberliegend mittels einer als Schalter dienenden zusätzlichen Funkenstrecke und über einen Pulsformer sowie einen Vorwiderstand aus einer Hochspannungs-Gleichstromquelle aufgeladen, um bei Entladung zunächst die pulsformende Funkenstrecke und danach die Mikrowellen generierende Funkenstrecke ansprechen zu lassen.

Etwa aus der US 4,845,378 A ist es bekannt, als Hochspannungsquelle Kondensatorbatterien über Funkenstreckenschalter nach Art der Marx'schen Stoßspannungsschaltung umzuschalten, dort zum Generieren eines elektromagnetischen Pulses für die Simulation eines realen nuklear ausgelösten Impulses.

Der Effekt einer intensiven örtlichen Mikrowellenabstrahlung wird als nichtletale Waffe gegen gegnerische Kommunikationssysteme propagiert (vgl. DER SPIEGEL, Heft 7/1997, S. 53 ff, Ende des 3. Absatzes der linken Spalte von S. 54).

Aus der Auslegeschrift DE 15 91 225 ist ein Mikrowellengenerator mit an umzuladende Kondensatoren angeschlossener Abstrahlantenne und mit einem Hochspannungsgenerator als Energielieferanten für das Aufladen der Kondensatoren bekannt, wobei der Hochspannungsgenerator über die Abstrahlantenne an eine Folge von Kondensatoren angeschlossen ist, die sukzessive einander parallel schaltbar sind, wobei eine koaxiale Folge von ringförmigen Kondensatoren vorgesehen ist, von denen jeweils eine Elektrode mit den anderen zusammengeschaltet ist, während die andere Elektrode über einen Schalter an die nächst benachbarte anschließbar ist. Bei diesem bekannten Mikrowellengenerator sind die in einer koaxialen Folge vorgesehenen ringförmigen Kondensatoren von einem zylindrischen äußeren hohlen Leiter, der eine gemeinsame Außenelektrode bildet, und von Leitungsabschnitten eines Mittelleiters eines Koaxialkabels gebildet. Die Leitungsabschnitte sind einfach geradlinig ausgebildet und voneinander durch Funkenstrecken getrennt. Der in der Auslegeschrift DE 15 91 225 veröffentlichte Mikrowellengenerator stellt eine fixe Anordnung dar und lässt sich nicht einfach konstruktiv beeinflussen. Er lässt sich daher auch nicht einfach auf unterschiedliche Einsatzszenarien optimieren.

Der Erfindung liegt die technische Problemstellung zugrunde, dafür einen Mikrowellengenerator und ein Verfahren zum Abstrahlen von Mikrowellenenergie hinsichtlich der Energieversorgung autark, hinsichtlich der apparativen Abmessungen unproblematisch verbringbar sowie vor allem hinsichtlich des Strahlungsspektrums und der abgestrahlten Energiedichte auf unterschiedliche Einsatzszenarien optimierbar auszulegen.

Diese komplexe Aufgabe ist durch die in den Hauptansprüchen jeweils angegebene Kombination der für die Erfindung wesentlichen Merkmale gelöst

Danach wird die mittels etwa eines kleinbauenden batteriegespeisten Marx-Generators gewinnbare Hochspannungsenergie antennenseitig in eine Folge sukzessiv zueinander parallel zu schaltender Kondensatoren eingespeist. Die in kurzen Intervallen schrittweise aufeinander folgende Parallelschaltung erfolgt über je eine Funkenstrecke, sobald der davor gelegene Kondensator dem darauf folgenden Kondensator gegenüber auf die Lichtbogenspannung für Durchschlag der Funkenstrecke zu diesem darauf folgenden Kondensator hin aufgeladen ist. Der dabei ablaufende Ladevorgang wird primär durch die Kapazität des neu aufzuladenden Kondensators bestimmt und ist deshalb über dessen Elektrodengröße, den Elektrodenabstand und das Dielektrikum zwischen den Kondensatorelektroden konstruktiv beeinflussbar.

Noch während des Nachladens aus dem kapazitiven Hochspannungsgenerator setzt also die Folge der Überschläge zum Laden der jeweils folgenden Kondensatoren ein, mit dem über die Antenne noch eingespeisten Ladestrom und parallel dazu aus dem jeweils vor der aktuell ansprechenden Lichtbogenstrecke aufgeladenen Kondensator. Mit jedem solchen Überschlag-Schaltvorgang zum Laden des nächst folgenden Kondensators wird eine steile, hochfrequent unterlagerte Stromflanke im Ladestrom über die Antenne ausgelöst, wobei ein Teil der Energie vom neuen Lichtbogen her der Einspeisung entgegen und damit zur Abstrahlantenne hin als abzustrahlende Mikrowellenenergie zurückfließt, während der andere Teil über die Lichtbogenstrecke zum Aufladen des nächstfolgenden Kondensators beiträgt - bis die daran anschließende Funkenstrecke ihrerseits anspricht; und so fort. Die Anzahl der in einem abgestrahlten Pulspaket aufeinderfolgenden Mikrowellenimpulse ist also gleich der Anzahl der Schaltstrecken bei den sukzessive einander parallelzuschaltenden Kondensatoren.

Die Pulse im Pulspaket haben je nach der mechanischen Auslegung des Systems bei gasförmigem Dielektrikum eine Folgefrequenz in der Größenordnung von typisch 150 MHz mit einem Strahlungsspektrum um 100 MHz je Schaltstrecke, das sich bei z.B. sechs Schaltstrecken zu einem abgestrahlten Mikrowellenspektrum um 600 MHz überlagert. Das Mikrowellenspektrum läßt sich also hinsichtlich Rauschlänge (d.h. Anzahl der Impulse im Impulspaket) und Spektralinhalt über die mechanische Auslegung des Mikrowellengenerators in weiten Grenzen konstruktiv beeinflussen, vor allem hinsichtlich seiner aufeinander folgend parallel zu schaltenden Kondensatoren.

Der konstruktive Aufbau eines Mikrowellengenerators auf der funktionalen Basis der Impulsfolgeerzeugung über eine zeitlich gestaffelt zuschaltende Kondensatorkette noch während deren Aufladens aus dem Hochspannungsgenerator besteht vorzugsweise aus einer Anzahl aufeinander folgend angeordneter Kondensatorelektroden, die geometrisch als Aufeinanderfolge von Funkenstrecken ausgelegt sind, während deren jeweils gegenüberliegenden Kondensatorelektroden zusammengeschaltet sind. Die stirnseitigen gegenseitigen Abstände der Funkenstrecken werden durch zu ihnen parallel gelegene Distanzhalter gewährleistet. Der erste aus dem Hochspannungsgenerator aufzuladende dieser Folge von Kondensatoren ist an seiner Funkenstrecken-Elektrode mit der Abstrahlantenne elektrisch leitend verbunden. Die ist vorzugsweise zur Impedanzanpassung als kegelstumpfförmiger Leiter ausgebildet. Die Hochspannungseinspeisung in die Kondensatorkette erfolgt zweckmäßigerweise nicht beim Anschluss zwischen Abstrahlantenne und erster Funkenstrecke, sondern über die Abstrahlantenne, um schon die vom Lichtbogen-Schaltvorgang ausgelöste heftige Stromoszillation auf dieser Zuführung für die Mikrowellenabstrahlung mit zu erfassen.

Zur näheren Ausbildung der vorstehend umrissenen Erfindung durch Weiterbildungen und Abwandlungen sowie deren Funktionen und Vorteilen wird außer auf die weiteren Ansprüche auch auf nachstehende Beschreibung eines in der Zeichnung unter Beschränkung auf das Wesentliche stark abstrahiert und nicht ganz maßstabsgerecht skizzierten bevorzugten Realisierungsbeispiels zur erfindungsgemäßen Lösung verwiesen. In der Zeichnung zeigt:
- Fig. 1: im unterbrochenen Axial-Längsschnitt hinter einer Abstrahlantenne einen koaxialen Stapel von Lichtbogen-Schaltstrecken, die zugleich Elektroden von zukzessive einander parallel zu schaltenden Kondensatoren sind,
- Fig. 2: dem mechanischen Aufbau örtlich zugeordnet das elektrische Ersatzschaltbild der Anordnung nach Fig. 1 und
- Fig. 3: dem mechanischen Aufbau nach Fig. 1 zugeordnet ein hinsichtlich seines spektralen Inhalts stark vergröbertes Impuls-Zeit-Diagramm.

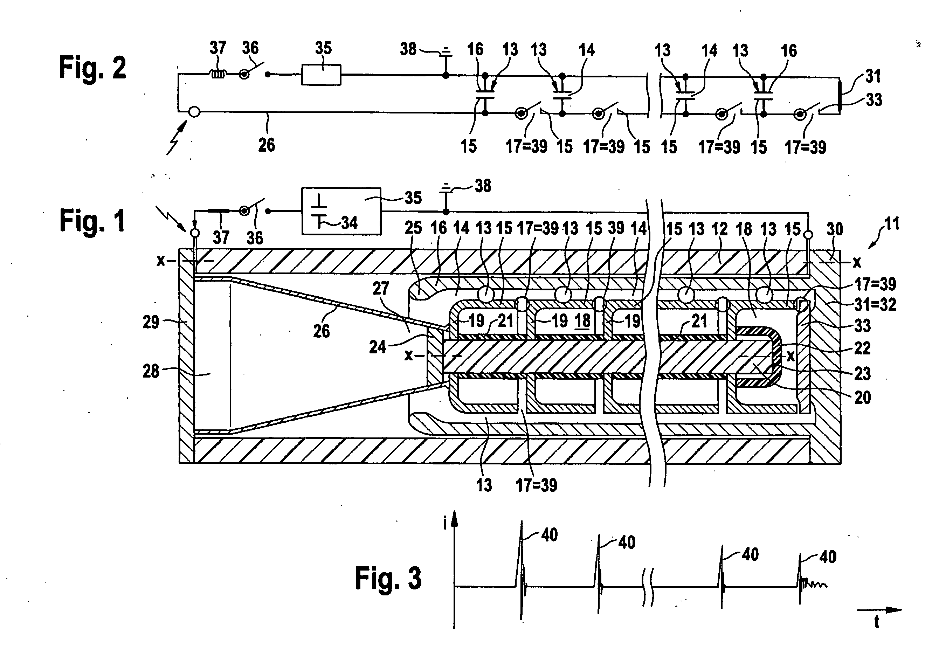

Der in Fig. 1 im unterbrochenen Axial-Längsschnitt skizzierte, koaxial aufgebaute Mikrowellengenerator 11 besteht im wesentlichen aus einem rohrförmigen Gehäuse 12 aus hochspannungsfestem Isoliermaterial, innerhalb dessem ein axialer Stapel hohlzylindrischer Kondensatoren 13 angeordnet ist. Die weisen beiderseits ihres kapazitätswirksamen Dielektrikums 14, mit dem das ganze Gehäuse 12 gefüllt ist, ringförmige Elektroden 15, 16 auf. Die ringförmigen inneren Elektroden 15-15 der Kondensatoren 13 sind im säulenförmigen Stapel jeweils über einen lichten axialen Abstand 17 voneinander distanziert. Deren äußere oder Gegen-Elektroden 16 sind, wie aus Fig. 2 ersichtlich, einander elektrisch parallelgeschaltet und deshalb gemäß Fig. 1 konstruktiv einstückig als den Elektrodenstapel 15-15 koaxial umgebendes Rohr ausgebildet. Aber auch der entgegengesetzte Aufbau (also außenliegende geschaltete Elektroden 15 bei einer innenliegenden stabförmig durchgehenden Gegenelektrode 16) ist realisierbar.

Für den Beispielsfall der Fig. 1 verläuft also über den axialen Stapel von zueinander axial distanzierten ringförmigen inneren Elektroden 15 eine für alle Kondensatoren 13 durchgehend rohrförmige Gegenelektrode 16 koaxial längs der Innenwandung des Gehäuses 12.

Um im Gehäuse-Inneren die ringförmigen Elektroden 15 einfach montieren zu können, sind sie als die hohlzylindrischen Wandungen jeweils eines Topfes 18 ausgebildet, dessen zentral gelochter Boden 19 von einem allen solchen Töpfen 18 gemeinsamen rundstabförmigen Träger 20 aus hochspannungsfestem Material spielfrei durchquert wird. Die axialen Abstände 17 zwischen den ringförmigen Elektroden 15 bzw. zwischen ihren Topfböden 19 sind nach Maßgabe der axialen Elektrodenlängen durch die Längen von hülsenförmigen Abstandselementen 21 aus hochspannungsfestem Isoliermaterial bestimmt, die zwischen den axial aufeinander folgenden Böden 19 ebenfalls auf dem Isolierstoff-Träger 20 gehaltert sind. Mittels einer vor dem freien Stirnende 23 des Trägers 20 aufgeschraubten Stirnkappe 22 ist der axiale Stapel aus Topfböden 19 und zwischen ihnen gelegenen Abstandselementen 21 gegeneinander und gegen ein Widerlager 24 am gegenüberliegenden Stirnende des Trägers 20 axial verspannt. In jenem axial gegenüberliegenden Bereich endet die den Stapel rohrförmig umgebende Gegenelektrode 16 mit einem im Interesse der Hochspannungs-Überschlagsfestigkeit dem Feldlinienverlauf grob folgenden balligen Bund 25.

Eine im Interesse einer Impedanzanpassung kegelstumpfförmige oder wie skizziert hohlkegelstumpfförmige Abstrahlantenne 26 ist an ihrer kleineren Basis von dem hier axial eingreifenden Träger 20 bzw. dem an ihm vorgesehenen Widerlager 24 radial zentriert und zugleich durch axiale Anlage gegen den ersten Boden 19 der Stapels von Elektrodentöpfen 18 an diesen und damit an die erste Funkenstrecke 17 elektrisch angeschlossen. Beim gegenüberliegenden Stirnende, also im Bereiche ihrer großen Basis 28 ist die kegelstumpfförmige Antenne 26 radial an der Innenmantelfläche des Gehäuses 12 positioniert und axial durch einen vor dem Gehäuse 12 befestigten Deckel 29 eingespannt.

Axial gegenüberliegend ist, für die Halterung der rohrförmigen Gegenelektrode 16 im Gehäuse 12, ein Flansch 30 vorgesehen, der wie skizziert einstückig mit der Gegenelektrode 16 ausgebildet sein kann und dann zugleich als Gehäuseboden 31 sowie als Anschlussleiter 32 zu einer scheibenförmigen Abschlusselektrode 33 vor dem freien Stirnrand der dem Antennenanschluß gegenüberliegenden, letzten der ringförmigen Elektroden 15 dient.

Zum Betrieb dieses Mikrowellengenerators 11 wird die Kondensatorbatterie 34 eines beispielsweise batteriebetriebenen kleinbauenden Marx'schen Hochspannungsgenerators 35 über einen Betriebsschalter 36 (vorzugsweise in der Bauform einer selbstzündenden oder einer fremdgetriggerten Funkenstrecke) und die Induktivität 37 der Zuleitung an die elektrisch leitende Struktur der Abstrahlantenne 26 gelegt. Über diese fließt ein Ladestrom in den ersten der Kondensatoren 13, bis dessen innere Elektrode 15 der auf Massepotential 38 liegenden Gegenelektrode 16 gegenüber und insbesondere der Ringelektrode 15 des nächstfolgenden, noch ungeladen auf Anfangspotential liegenden Kondensators 13 gegenüber auf eine Spannung aufgeladen ist, welche den Abstand 17 zu der axial nächstfolgenden Ring-Elektrode 15 durchzünden lässt. Der lichte axiale Abstand 17 dient also als Lichtbogen-Schalter 39 zum nach Maßgabe der Ladezeitkonstante des vorangehenden Kondensators 13 verzögerten Beginn des Aufladens des nächstfolgenden der Kondensatoren 13-13.

Dieses zukzessive Ansprechen der Lichtbogen-Schalter 39 erfolgt noch während des Umladevorganges aus dem Hochspannungsgenerator 35 in den Stapel der Kondensatoren 13-13 hinein und hat somit hinsichtlich Amplitude und Frequenz extreme Oszillationen des Ladestromes über die Antenne 26 zur Folge, die als Pulspaket von Mikrowellenenergie abgestrahlt werden. Hinzu kommt, dass aufgrund der Wellenwiderstands-Anpassung am Lichtbogen von der ringförmigen Elektrode 15 des gerade geladenen Kondensators 13 zur ringförmigen Elektrode 15 des nächstfolgenden, nun über den Schalter 39 zu ladenden Kondensator 13 hinsichtlich Energiebilanz und Ausbreitungsrichtung eine Spaltung dahingehend eintritt, dass ein Teil der Energie an der Lichtbogenstrecke des Schalters 39 zur Abstrahlantenne 26 hin zurück reflektiert wird, was die Energiebilanz der Mikrowellenabstrahlung über die Antenne 26 vergrößert, während der Rest der Energie über den Lichtbogen des Schalters 39 zum Aufladen des nächstfolgenden Kondensators 13 aus dem zuvor aufgeladenen führt, ergänzt um den aus dem Hochspannungsgenerator 35 noch anstehenden Ladestrom. Wenn so von dessen ringförmiger Elektrode 15 zu derjenigen des nächstfolgenden Kondensators 13 eine hinreichende Potentialdifferenz über die Strecke des nächstfolgenden Schalters 39 aufgebaut ist, zündet auch dort ein Lichtbogen, und abermals kommt es zu den beschriebenen Oszillationen mit Aufspaltung der Energie in einen zum nächsten Kondensator 13 führenden Anteil und einen über die noch anstehenden Funkenstrecken der zuvor schon geschlossenen Schalter 39 zur Abstrahlantenne 26 zurück reflektierenden Anteil von vorzugsweise gleicher Größe; und sofort. Der letzte dieses Stapels parallelgeschalteter Kondensatoren 13 wird dann über den Lichtbogen seines Schalters 39 und die Abschlusselektrode 33 nur noch kurzgeschlossen, was aber abermals heftige Oszillationen großer Amplitude und damit wieder ein Beitrag zur Mikrowellenabstrahlung auslöst.

So entsteht durch die rasche zeitliche Aufeinanderfolge der Umladevorgänge über den Stapel von Kondensatoren 13-13, während des Endladens des Hochspannungsgenerators 35 über die Antenne 26 in diesen Kondensator-Stapel 13-13 hinein, ein wie in Fig. 3 über der Zeit skizziertes Pulspaket aus einer raschen Folge jeweils kurzzeitiger, sehr stark oszillierender Impulse 40. Deren Höhe sowie das in ihnen enthaltene Frequenzspektrum lassen sich durch die Kapazitäten der Kondensatoren 13, die nicht untereinander gleich sein müssen, variieren, also insbesondere durch den radialen Abstand zwischen den Elektroden 15-16, durch die Größe der einander gegenüberstehenden Elektrodenflächen (15 gegenüber 16) und durch das Dielektrikum zwischen beiden, aber auch beeinflussbar durch das von Elektrodenform und -abstand bestimmte Ansprechverhalten der Lichtbogen-Schalter 39 Auch der zeitliche Abstand zwischen zwei Impulsen 40 wird von den Kapazitäten 13 beeinflusst, maßgeblich aber durch die Systeminduktivität 37 im Ladestromkreis zu den Kapazitäten 13 bestimmt. Die Anzahl der aufeinanderfolgenden Impulse und damit die zeitliche Länge des Pulspaketes der Mikrowellenabstrahlung sind durch die Anzahl der voreinander gelegenen Elektroden 15 variierbar.

Gegenüber konventionellen koaxialen Einzelpuls-Antennen hat die rasche Folge der Impulse 40 eine Erhöhung der Mittenfrequenz des abgestrahlten Spektrums zur Folge. Der Pulsabstand im Impulspaket und das daraus abgestrahlte Frequenzspektrum lassen sich über die Länge der geschalteten Ringelektroden 15 und deren Lichtbogen-Ansprechverhalten beeinflussen. Eine typische Auslegung mit sechs Funkenstreckenschaltern 39 hat eine durch die Ladeinduktivität 37 bestimmte Ansprechfolge von 10 ns und führt im Impulspaket 40 ein durch die Kapazitäten 13 bestimmtes Frequenzgemisch um 600 MHz. Bei einer Auslegung des Mikrowellengenerators 11 auf ein niedrigeres Abstrahl-Frequenzspektrum vergrößert sich die abgestrahlte Energie. Im übrigen erhöht die abgestrahlte Energie sich mit dem Quadrat der Hochspannungs-Ladespannung aus dem Generator 35 und mit der Antennenkapazität. Die ist proportional zur im Gehäuse 12 bestehenden Dielektrizitätskonstante. Deshalb ergibt sich eine spürbare Leistungssteigerung, bei reduziertem Spektrum wenn das Gehäuse 12 statt mit Gas mit einem isolierenden Stoff höherer Dielektrizitätskonstante gefüllt wird, wie insbesondere mit destilliertem Wasser oder mit Öl.

So läßt sich erfindungsgemäß eine intensive Mikrowellenabstrahlung besonders großer Bandbreite und Energie über eine relativ längere Zeitdauer erzielen, indem die Abstrahlung nicht beim Entladen zuvor aufgeladener Kondensatoren über die Antenne erfolgt, sondern während des Entladens des kapazitiven Hochspannungsgenerators 35 über die Antenne 26 in eine Reihe von sukzessive parallel zu schaltenden Kondensatoren 13 hinein. Die sind vorzugsweise im Anschluß an die Antenne 26 als konzentrischer Stapel aufgebaut, von denen die äußeren, auf Bezugspotential liegenden Elektroden 16 als durchgehendes Rohr ausgebildet sind, innerhalb dessen auf einem Träger 20 axial derart distanziert zueinander Ringelektroden 15 angeordnet sind, daß sie zugleich als die Elektroden von Lichtbogen-Schaltern 39 zum sukzessiven Zuschalten von nachfolgenden Kondensatoren 13 wirken. Das Schalter-Ansprechverhalten und die Ladezeitkonstanten des damit jeweils zugeschalteten Kondensators 13 sowie deren Anzahl bestimmen die Länge des Paketes von sehr hochfrequenten Einzelimpulsen 40 und damit die abgestrahlte Mikrowellenenergie, die sich durch Kapazitätserhöhung der Kondensatoren 13 noch steigern lässt.

## Patentansprüche

1. Mikrowellengenerator (11) mit an umzuladenden Kondensatoren (13) angeschlossener Abstrahlantenne (26) und mit einem Hochspannungsgenerator (35) als Energielieferanten für das Aufladen der Kondensatoren (13), wobei der Hochspannungsgenerator (35) über die Abstrahlantenne (26) an eine Folge von Kondensatoren (13) angeschlossen ist, die sukzessive einander parallel schaltbar sind, wobei eine koaxiale Folge von ringförmigen Kondensatoren (13) vorgesehen ist, von denen jeweils eine Elektrode (16) mit den anderen zusammengeschaltet ist, während die andere Elektrode (15) über einen Schalter (39) an die nächstbenachbarte anschließbar ist,
**dadurch gekennzeichnet,**
**dass** die ringförmigen Elektroden (15) topfförmig mit zentral gelochtem Boden (19) ausgestaltet sind, mittels dessen sie auf einen Träger (20) aufgereiht sind.

2. Mikrowellengenerator nach Anspruch 1,
**dadurch gekennzeichnet,**
**dass** zwischen den Topf-Böden (19) Abstandselemente (21) auf dem Träger (20) angeordnet sind.

3. Mikrowellengenerator nach Anspruch 2,
**dadurch gekennzeichnet,**
**dass** die topfförmigen Elektroden (15) mittels einer Stirnkappe (22) und der Abstandselemente (21) zwischen ihren Böden (19) axial auf dem Träger (20) verspannt sind.

4. Mikrowellengenerator nach einem der Ansprüche 1 bis 3,
**dadurch gekennzeichnet,**
**dass** eine kegelstumpfförmige Abstrahlantenne (26) vom Träger (20) zentriert und mit ihrer kleineren Basis (27) an den ihr benachbarten ersten Kondensator (13) auf dem Träger (20) elektrisch angeschlossen ist.

5. Mikrowellengenerator nach einem der Ansprüche 1 bis 3,
**dadurch gekennzeichnet,**
**dass** die Abstände (17) zwischen den topfförmigen Elektroden (15) und deren Stirnprofile als Lichtbogen-Schalter (39) ausgelegt sind.

6. Mikrowellengenerator nach einem der vorangehenden Ansprüche,
**dadurch gekennzeichnet,**
**dass** der von der Energieeinspeisung abgelegene letzte Kondensator (13) einen Lichtbogen-Schalter (39) zu einer Abschlusselektrode (33) aufweist, die auf dem Potential der Gegenelektrode (16) liegt.

## Claims

1. Microwave generator (11) having a transmitting antenna (26) which is connected to capacitors (13), whose charge is to be reversed, and having a high-voltage generator (35) as energy suppliers for the charging of the capacitors (13), with the high-voltage generator (35) being connected to a series of capacitors (13) via the transmitting antenna (26), which capacitors (13) can be successively connected in parallel with one another, with a coaxial series of annular capacitors (13) being provided, one electrode (16) of each of which capacitor is connected to the others, while the other electrode (15) can be connected via a switch (39) to the next closest one,
**characterized**
**in that** the annular electrodes (15) are in the form of pots with a base (19) with a hole in its centre, by means of which they are arranged in a row or rows on a mount (20).

2. Microwave generator according to Claim 1,
**characterized**
**in that** spacing elements (21) are arranged on the mount (20) between the pot bases (19).

3. Microwave generator according to Claim 2,
**characterized**
**in that** the pot-shaped electrodes (15) are braced axially on the mount (20) by means of an end cap (22) and the spacing elements (21) between their bases (19).

4. Microwave generator according to one of Claims 1 to 3,
**characterized**
**in that** a truncated conical transmitting antenna (26) is centred by the mount (20) and its smaller base (27) is electrically connected to the first capacitor (13) adjacent to it on the mount (20).

5. Microwave generator according to one of Claims 1 to 3,
**characterized**
**in that** the distances (17) between the pot-shaped electrodes (15) and their end profiles are designed as arcing switches (39).

6. Microwave generator according to one of the preceding claims,
**characterized**
**in that** the last capacitor (13) at the remote end from the power feed has an arcing switch (39) for a terminating electrode (33), which is at the same potential as the opposing electrode (16).

## Revendications

1. Générateur de micro-ondes (11) comprenant une antenne émettrice (26) connectée à des condensateurs (13) dont la charge doit être transférée, et un générateur de haute tension (35) en tant que fournisseur d'énergie pour la charge des condensateurs (13), le générateur de haute tension (35) étant connecté par l'intermédiaire de l'antenne d'émission (26) à une séquence de condensateurs (13) qui peuvent se connecter les uns aux autres successivement, une séquence coaxiale de condensateurs annulaires (13) étant prévue, dont chaque électrode (16) est connectée aux autres, alors que l'autre électrode (15) peut être connectée par l'intermédiaire d'un commutateur (39) à l'électrode voisine, **caractérisé en ce que** les électrodes annulaires (15) sont conformées en pots avec un fond perforé au centre (19), au moyen duquel elles sont rangées les unes à cRté des autres sur un support (20).

2. Générateur de micro-ondes selon la revendication 1, **caractérisé en ce que** des espaceurs (21) sont disposés entre les fonds de pot (19) sur le support (20).

3. Générateur de micro-ondes selon la revendication 2, **caractérisé en ce que** les électrodes en forme de pot (15) sont contraints axialement sur le support (20) au moyen d'une coiffe frontale (22) et des espaceurs (21) entre leurs fonds (19).

4. Générateur de micro-ondes selon l'une quelconque des revendications 1 à 3, **caractérisé en ce qu'**une antenne émettrice de forme tronconique (26) est centrée par le support (20) et est connectée électriquement par sa plus petite base (27) au premier condensateur (13) voisin de celle-ci sur le support (20).

5. Générateur de micro-ondes selon l'une quelconque des revendications 1 à 3, **caractérisé en ce que** les espaces (17) entre les électrodes en forme de pots (15) et leurs profilés avant sont dimensionnés comme commutateurs à arc (39).

6. Générateur de micro-ondes selon l'une quelconque des revendications précédentes, **caractérisé en ce que** le dernier condensateur (13) éloigné de l'alimentation en énergie présente un commutateur à arc (39) près d'une électrode de fermeture (33) qui se trouve au potentiel de la contre-électrode (16).
